# EUROPÄISCHE PATENTSCHRIFT

(11) **EP 0 476 219 B1**
(45) Veröffentlichungstag und Bekanntmachung des Hinweises auf die Patenterteilung: **28.12.1994**
(21) Anmeldenummer: 91103903.0
(22) Anmeldetag: 14.03.1991
(51) Int. Cl.: C23C 14/50, C23C 14/54

(54) **Vorrichtung für den Transport von Substraten**
Apparatus for transporting substrates
Dispositif pour le transport de substrats

(30) Priorität: 21.09.1990 DE 4029905
(43) Veröffentlichungstag der Anmeldung: 25.03.1992
(73) Patentinhaber: LEYBOLD AKTIENGESELLSCHAFT, D-63450 Hanau (DE)
(72) Erfinder: Mahler, Peter, W-6452 Hainburg 2 (DE); Michael, Klaus, Dr., W-6460 Gelnhausen (DE); Gegenwart, Rainer, Dr., W-6074 Rödermark (DE); Scherer, Michael, Dr., W-6458 Rodenbach (DE)

(56) Entgegenhaltungen:
- EP-A- 0 346 815
- DE-A- 3 941 502
- PATENT ABSTRACTS OF JAPAN, vol. 9, no. 19 (E-292)(1742), 25. Januar 1985; & JP-A-59 167 013

## Beschreibung

Die Erfindung betrifft eine Vorrichtung für den Transport von Substraten bei Vakuum-Beschichtungsanlagen mit mehreren Stationen, mit Substrathaltern mit etwa plattenförmiger, flacher, parallelepipeder Konfiguration, die in lotrechter Stellung - entlang eines vorgegebenen Transportweges - durch die Stationen bewegbar sind, und mit Paaren von Wälzkörpern, Gleitsteinen oder Rollen, die im Zusammenwirken mit Schienen die Substrathalter halten und führen und die jeweils im Bereich ihres Fußteils unterhalb der an den Substrathaltern befestigbaren Substraten vorgesehen sind.

Die zum Einsatz kommenden Substrathalter sind entweder Platten mit entsprechend den Substraten geformten Ausschnitten oder Rahmen mit Streben, an denen die Substrate befestigt werden. Im allgemeinen dient ein Substrathalter zur Aufnahme einer Vielzahl von Substraten.

Durch die US-A-4 042 128 ist eine Transporteinrichtung der eingangs beschriebenen Gattung bekannt, bei der plattenförmige Substrathalter bei vertikaler Lage ihrer Hauptebene an ihren oberen und unteren Längskanten zwischen Rollen geführt werden, die um senkrechte Achsen drehbar sind. An ihren Unterkanten liegen die Substrathalter zusätzlich auf Stützrollen mit horizontaler Drehachse auf. Die unteren Führungsrollen sind jedoch nicht im Stande, die Substrathalter allein in genau vertikaler Stellung zu halten und zu transportieren, so daß eine stabile Positionierung nur unter Zuhilfenahme der oberen Führungsrollen möglich ist.

Bekannt ist auch eine Transporteinrichtung für Vakuum-Beschichtungsanlagen aus EP-A-0 254 145 mit mehreren Stationen und mit Rollensystemen für die Führung und den Vorschub von im wesentlichen zweidimensionalen Substrathaltern in senkrechter Stellung entlang eines vorgegebenen Transportweges durch die Stationen, wobei im Bereich der Unterkante der Substrathalter paarweise Führungsrollen angeordnet sind, die den Substrathalter zwischen sich aufnehmen und die um senkrechte Achsen drehbar sind, wobei die Substrathalter ausschließlich im Bereich ihrer Unterkante durch die Rollensysteme geführt sind und die Führungsrollen mit Laufflächen versehen sind, die auf mindestens einer Führungsrolle eines Rollenpaares jeweils am unteren und am oberen Ende angeordnet sind, wobei die jeweils andere Führungsrolle des gleichen Rollenpaares mindestens eine Lauffläche aufweist und wobei die mindestens drei Laufflächen eines Rollenpaares in bezug auf den Substrathalter eine kippsichere Einspannung bilden. Dieser bekannten Transporteinrichtung lag die Aufgabe zugrunde, die Störung des Beschichtungsvorganges durch herabrieselndes Schichtmaterial soweit wie möglich auszuschließen.

Weiterhin ist es aus DE-A-3 107 914 bekannt, die zu beschichtenden Substrate in einer besonderen Schleusenkammer mit einer Heizeinrichtung thermisch vorzubehandeln. Schließlich hat man bereits in EP-A-0 346 815 vorgeschlagen, den Substrathalter bei einer Transporteinrichtung für eine Vakuum-Beschichtungsanlage mit einem Fußteil auszustatten, das auf ortsfesten Schienen gleitet.

Der vorliegenden Erfindung liegt insbesondere die Aufgabe zugrunde, eine Substrathalterung für mehrere Substrate zu schaffen und die Substrathalterung derart auszubilden, daß die Substrate gemeinsam von einer einzigen Heizquelle gleichzeitig und mit gleicher Intensität temperierbar sind. Darüber hinaus sollen die Substrathalter entlang des Transportweges absolut störungsfrei und mit einem Minimum an seitlichen Bewegungen (Erschütterungen) gehalten und geführt werden.

Diese Aufgabe wird erfindungsgemäß dadurch gelöst, daß das Fußteil des Substrathalters mit einem Paar parallel und im Abstand zueinander verlaufender, in einer lotrechten Ebene angeordneten Schienen versehen ist, deren einander zugekehrte Schmalseiten Längsnuten aufweisen, die mit Rollen oder Gleitsteinen korrespondieren, die ortsfest am Bodenteil der Vorrichtung gelagert sind und die jeweils in Reihen entsprechend dem Verlauf der Nuten in übereinander liegenden, vertikalen Ebenen im Abstand zueinander vorgesehen sind, wobei der Substrathalter eine sich von oben her bis in den Bereich seines Fußteils erstreckende, parallel zu den Schienen verlaufende, schachtförmige Aussparung aufweist, in die beim Durchlauf durch die Station ein oberhalb des Substrathalters angeordneter, flacher, sich lotrecht nach unten zu erstreckender Heizkörper hineinragt.

Vorzugsweise weist der Substrathalter zwei rahmenförmig ausgebildete, in parallelen Ebenen angeordnete Seitenteile auf, die zwischen sich die schachtförmige Aussparung bilden, in deren fensterartige Öffnungen die Substrate einlegbar sind, wobei die Seitenteile einstückig ausgebildet sind oder mit dem Fußteil vernietet, verschraubt oder über Gelenke verbunden sind.

Die Erfindung läßt die verschiedensten Ausführungsmöglichkeiten zu; eine davon ist in der anhängenden Zeichnung schematisch näher dargestellt, die den Schnitt quer durch eine Vorrichtung zeigt.

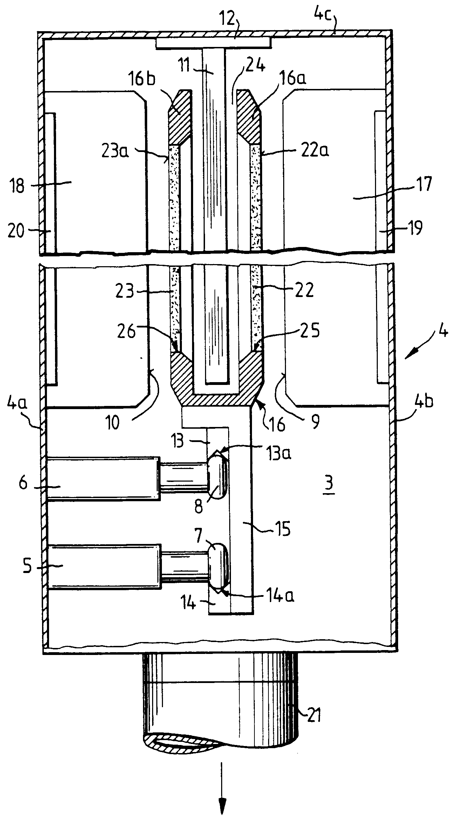

Wie die Zeichnung zeigt, besteht die Vorrichtung aus den in der Beschichtungskammer 3 an der einen Seitenwand 4a des Gehäuses 4 an sich horizontal erstreckenden Armen 5, 6 drehbar gelagerten Rollen 7, 8, den beiden an den Seitenwänden 4a, 4b fest angeordneten Kathoden 9, 10, dem am oberen Wandteil 4c bzw. am Isolator 12 gehaltenen plattenförmigen Heizelement 11, dem mit Schienen 13, 14 versehene Fußteil 15 des im Querschnitt U-förmig ausgeformten Substrathalters 16, den beiden rahmenförmigen, die Substrate 22, 23 haltenden Seitenteilen 16a, 16b des Substrathalters 16 und den beiden an den Seitenwänden 4a, 4b fest angeordneten Kathoden 19, 20 mit ihren Kathodenblenden 17, 18 und schließlich dem Absaugstutzen 21 einer nicht näher dargestellten Turbomolekularpumpe.

Während des Betriebs der in der Zeichnung schematisch dargestellten Beschichtungsstation werden die Substrate 22, 23 in einer Richtung lotrecht zur Schnittebene bewegt, bis sie den Kathoden 19, 20 gegenüberstehen, wie dies aus der Zeichnung ersichtlich ist.

Nach der Beschichtung der Außenflächen 22a, 23a der Substrate 22, 23 werden diese in der gleichen Richtung (lotrecht zur Zeichenebene) bis zur nächsten Bearbeitungsstation weiterbewegt. Die scheibenförmigen Substrate 22, 23 werden von den sie rahmenförmig umschließenden Seitenteilen 16a, 16b des Substrathalters 16 gehalten, der seinerseits fest mit dem Fußteil 15 verbunden oder einstückig mit diesem ausgebildet ist. Das Fußteil 15 ist mit einem Paar von Schienen 13, 14 verschraubt oder verschweißt, die ihrerseits Längsnuten 13a, 14a aufweisen, in denen Rollen 7 bzw. 8 laufen, die in zwei Reihen in Abständen hintereinanderliegend drehbar auf Armen 5 bzw. 6 gelagert sind. Der Abstand, den die Reihen von Rollen 5 bzw. 6 zueinander aufweisen, ist so gewählt, daß das Fußteil 15 auf diesen kippsicher gehalten und geführt ist.

Um sicherzustellen, daß die Substrate 22, 23 die für den Beschichtungsprozeß erforderliche Temperatur aufweisen, ist am oberen Wandteil 4c des Gehäuses 4 an einem Isolator 12 ein plattenförmiges Heizelement 11 befestigt, das in die schachtförmige Nut 24 hineinragt und das so bemessen ist, daß die Substrate 22, 23 von ihrer Rückseite her gleichmäßig aufgeheizt werden. Um Strahlungsverluste möglichst gering und die Temperierung beider Substrate 22, 23 auf gleichem Niveau zu halten, sind die jeweils zwischen dem Heizelement 11 und den Substraten 22, 23 verbleibenden Abstände gleich und möglichst gering bemessen.

### Bezugszeichenliste

- 3: Beschichtungskammer
- 4: Gehäuse
- 4a: Seitenwand des Gehäuses
- 4b: Seitenwand des Gehäuses
- 4c: oberes wandteil des Gehäuses
- 5: Arm
- 6: Arm
- 7: Rolle
- 8: Rolle
- 9: Kathode
- 10: Kathode
- 11: Heizelement
- 12: Isolator
- 13: Schiene
- 13a: Längsnut
- 14: Schiene
- 14a: Längsnut
- 15: Fußteil
- 16: Substrathalter
- 16a: Seitenteil des Substrathalters
- 16b: Seitenteil des Substrathalters
- 17: Kathodenblende
- 18: Kathodenblende
- 19: Kathode
- 20: Kathode
- 21: Absaugstutzen
- 22: Substrat
- 22a: Außenfläche des Substrats
- 23: Substrat
- 23a: Außenfläche des Substrats
- 24: schachtförmige Nut
- 25: fensterförmige Ausnehmung
- 26: fensterförmige Ausnehmung

## Patentansprüche

1. Vorrichtung für den Transport von Substraten bei Vakuum-Beschichtungsanlagen mit mehreren Stationen, mit Substrathaltern (16) mit etwa plattenförmiger, flacher, parallelepipeder Konfiguration, die in lotrechter Stellung entlang eines vorgegebenen Transportweges durch die Stationen bewegbar sind, und die mit Schienen (13, 14) zusammenwirken, die jeweils im Bereich ihres Fußteils (15) unterhalb der an den Substrathaltern (16) befestigbaren Substraten (22, 23) vorgesehen sind, ***dadurch gekennzeichnet*****,** daß das Fußteil (15) des Substrathalters (16) mit einem Paar parallel und im Abstand zueinander verlaufender, in einer lotrechten Ebene angeordneter Schienen (13, 14) versehen ist, deren einander zugekehrte Schmalseiten Längsnuten (13a, 14a) aufweisen, die mit Rollen (7, 8) oder Gleitsteinen korrespondieren, die ortsfest am Bodenteil der Vorrichtung gelagert sind, und die jeweils in Reihen entsprechend dem Verlauf der Nuten (13a, 14a) in übereinander liegenden, vertikalen Ebenen im Abstand zueinander vorgesehen sind, wobei der Substrathalter (16) eine sich von oben her bis in den Bereich seines Fußteils (15) erstreckende, parallel zu den Schienen verlaufende, schachtförmige Aussparung (24) aufweist, in die beim Durchlauf durch die Station ein oberhalb des Substrathalters (16) am oberen Wandteil (4c) angeordneter, flacher, sich lotrecht nach unten zu erstreckender Heizkörper (11) hineinragt.

2. Vorrichtung nach Anspruch 1, ***dadurch gekennzeichnet*****,** daß der Substrathalter (16) zwei rahmenförmig ausgebildete, in parallelen Ebenen angeordnete Seitenteile (16a, 16b) aufweist, die zwischen sich die schachtförmige Aussparung (24) bilden und in deren fensterartige Öffnungen (25, 26) die Substrate (22, 23) einlegbar sind, wobei die Seitenteile (16a, 16b) einstückig ausgebildet sind oder mit dem Fußteil (15) vernietet, verschraubt oder über Gelenke verbunden sind.

## Claims

1. Device for conveying substrates in vacuum coating installations having a plurality of stations, comprising substrate holders (16) which have an approximately laminar, flat, parallelepiped configuration, which can be moved in the vertical position through the stations along a predetermined conveyance path and which interact with rails (13, 14) provided in each case in the region of their base part (15) underneath the substrates (22, 23) which can be attached to the substrate holders (16), characterized in that the base part (15) of the substrate holder (16) is provided with a pair of rails (13, 14) which extend in parallel and at a distance from one another and are disposed in a vertical plane and whose mutually facing narrow sides have longitudinal grooves (13a, 14a) which match the rollers (7, 8) or sliding blocks which are mounted in a fixed position on the base part of the device and which are in each case provided in vertical planes situated one above the other and at a distance from one another in rows corresponding to the path of the grooves (13a, 14a), the substrate holder (16) having a well-like recess (24) which extends from the top down to the region of its base part (15) and extends parallel to the rails and into which a flat heater (11) disposed above the substrate holder (16) on the upper wall part (4c) and to be extended vertically downwards projects on passing through the station.

2. Device according to Claim 1, characterized in that the substrate holder (16) has two side parts (16a, 16b) which are of frame-like design and are disposed in parallel planes and which form the well-like recess (24) between them and into whose window-like openings (25, 26) the substrates (22, 23) can be inserted, the side parts (16a, 16b) being of integral design or riveted, screwed or joined via articulated joints to the base part (15).

## Revendications

1. Dispositif pour le transport de substrats dans des installations de revêtement sous vide avec plusieurs stations, comportant des porte-substrats (16) à configuration parallélépipédique, plate, approximativement en forme de plaque, qui peuvent être déplacés à travers les stations en position verticale - le long d'un chemin de transport prédéterminé, et qui coopèrent avec des rails (13, 14) qui sont prévus dans chaque région de leur pied (15) au-dessous des substrats (22, 23) fixés sur les porte-substrats (16), caractérisé en ce que le pied (15) du porte-substrats (16) est pourvu d'une paire de rails (13, 14) parallèles et s'étendant à distance l'un de l'autre, agencés dans un plan vertical, dont les petits côtés tournés l'un vers l'autre présentent des gorges longitudinales (13a, 14a) qui correspondent à des rouleaux (7, 8) ou à des patins qui sont montés stationnaires sur le fond du dispositif et qui sont prévus à distance les uns des autres dans des rangées respectives, selon le tracé des gorges (13a, 14a), dans des plans verticaux superposés, le porte-substrats (16) présentant un évidement (24) en forme de puits s'étendant parallèlement aux rails depuis le haut jusque dans la région de son pied (15), évidement dans lequel, lors du passage a travers la station, fait saillie un élément de chauffage (11) plat, qui s'étend verticalement vers le bas, logé au-dessus du porte-substrats sur la partie de paroi (4c).

2. Dispositif selon la revendication 1, caractérisé en ce que le porte-substrats (16) présente deux parties latérales (16a, 16b) réalisées en forme de cadre, agencées dans des plans parallèles, qui forment entre elles l'évidement (24) en forme de puits, dans les ouvertures (25,26) en forme de fenêtres duquel les substrats (22, 23) peuvent être placés, les parties latérales (16a, 16b) étant réalisées d'une seule pièce ou rivées, vissées ou reliées par des articulations avec le pied (15).
